# EUROPEAN PATENT APPLICATION

(11) **EP 2 395 563 A1**
(43) Date of publication of application: **14.12.2011**
(21) Application number: 10165576.9
(22) Date of filing: 10.06.2010
(51) Int. Cl.: H01L 31/052, H01L 31/05

(54) **Receivers for Concentrating Photovoltaic Systems and Methods for Fabricating the Same**

(71) Applicant: Megawatt Solar, Inc., Hillsborough, NC 27278 (US)
(72) Inventor: Clemens, J. Christopher, Chapel Hill, NC 27517 (US); Evans, Charles R., II, Chapel Hill, NC 27517 (US); Jones, Daniel, Durham, NC 27713 (US); Vendura, Eric, Hillsborough, NC 27278 (US); DeSena, Philip J., Raleigh, NC 27615 (US); Kelly, Ryan, Durham, NC 27701 (US); Poncheri, Michael, Durham, NC 27707 (US)
(74) Representative: Walker, Stephen

(57) **Abstract**

The present subject matter relates to receivers for concentrating photovoltaic systems and methods for fabricating such receivers. A receiver for a concentrating photovoltaic system can comprise a substrate, a plurality of electrical contact pads located on a first surface of the substrate, and a plurality of photovoltaic cells each having plurality of electrically conductive traces that are each electrically coupled to one of the electrical contact pads. In some embodiments, all of the conductive traces can be located on the back surface of the photovoltaic cells for conduction of electric current generated by the photovoltaic cells when illuminated. Alternatively, conductive traces can further be located on a front surface of the photovoltaic cells and can be electrically coupled to corresponding contact pads by electrical connectors. Regardless of the specific arrangement, the receivers can be fabricated using industry standard soldering techniques often used in the electronics industry.

## Description

### TECHNICAL FIELD

The subject matter described herein relates generally to the field of photovoltaic systems. More particularly, the subject matter disclosed herein relates to receivers for photovoltaic systems and methods for fabricating such receivers.

### BACKGROUND

Photovoltaic cells convert solar energy into electrical energy. One category of solar photovoltaic collectors is unconcentrated collectors, which directly intercept solar radiation for conversion into electrical energy. Because such systems receive the solar energy directly without any magnification, they are sometimes referred to as "one-sun" systems. The conventional method for assembling photovoltaic cells into rigid panels for power production using unconcentrated sunlight involves multiple steps. First, individual cells are strung into a linear circuit by soldering flexible flat wire (ribbon) to them. The cell strings are then assembled into a series or series-parallel two-dimensional array. The wired array is placed into a sandwich of backing material, fusible polymer (e.g., EVA), and transparent cover plate, and this sandwich is then vacuum laminated and mounted in a frame. A junction box with a bypass diode is then attached to the rear of the assembly. This process is labor-intensive and exposes the fragile cells to the risk of damage during each handling step. Some stages of the process, such as the cell stringing, can be automated, but the automation equipment is generally specialized to the task and can thus be quite expensive.

In contrast, concentrating photovoltaic systems seek to reduce at least some of these costs by reducing the total area of photovoltaic cells through the use of low-cost optics (e.g., mirrors or lenses) to focus sunlight. For systems employing concentration there is a need to develop alternative solar panels (typically referred to as "receivers" in concentrating photovoltaic applications) that incorporate smaller cells and better heat dissipation systems than those employed in panels fabricated for "one-sun" use. Smaller cells can manage the higher current densities generated by concentrated sunlight, and better thermal management systems are often used to dissipate the high levels of waste heat. It is possible to construct such smaller receivers for concentrating photovoltaic systems using the same methodology as employed in "one-sun" panels. The stringing operation can be applied to smaller cells and backing material in the fused sandwich could be replaced with a passive or active heat sink of adequate proportions.

However, despite these savings due to the smaller scale of receivers for use in concentrating systems, such methods can require even more specialized equipment than that employed in the fabrication of "one-sun" panels and often can not provide optimum thermal contact between the cells and the heat sink. Moreover, some conventional fusible polymers degrade rapidly under exposure to concentrated sunlight, so substitute materials are commonly employed. The combination in a photovoltaic receiver of smaller components, more sophisticated materials, and greater heat dissipation risks the necessity of higher fabrication costs that would negate some or all of the savings realized by reduction in cell area.

Accordingly, there exists a need for receivers for concentrating photovoltaic systems and methods for fabricating such receivers that reduce the material and assembly costs of photovoltaic receivers to a level below that of "one-sun" panels.

### SUMMARY

The subject matter described herein includes receivers for concentrating photovoltaic systems and methods for fabricating such receivers. In one aspect, a receiver for a concentrating photovoltaic system is provided. The receiver can comprise a substrate, at least a portion of which is thermally conductive, a plurality of electrical contact pads located on a first surface of the substrate, and a plurality of photovoltaic cells. Each of the photovoltaic cells can have a first surface for exposure to a light source during use and a second surface opposite the first surface. The second surface can includes a plurality of electrically conductive traces that extend across the second surface for conduction of electric current generated by the photovoltaic cells when illuminated, wherein at least a portion of each of the electrically conductive traces is electrically coupled to one of the electrical contact pads.

In another aspect, a method for fabricating a receiver for a concentrating photovoltaic system is provided. The method can comprise positioning a plurality of electrical contact pads on a first surface of a substrate, applying solder paste to the electrical contact pads, placing a plurality of photovoltaic cells on the electrical contact pads, applying heat to re-flow the solder paste, and removing application of the heat to solidify the re-flowed solder paste. Each of the photovoltaic cells can have a first surface for exposure to a light source during use and a second surface opposite the first surface. The second surface can include a plurality of electrically conductive traces that extend across the second surface for conducting electric current generated by the photovoltaic cells when illuminated, wherein the solder paste connects a portion of each of the electrically conductive traces to one of the electrical contact pads.

In yet another aspect, a receiver for a concentrating photovoltaic system is provided. The receiver can comprise a substrate, at least a portion of which is thermally conductive, a plurality of first electrical contact pads on a first surface of the substrate, a plurality of second electrical contact pads on the first surface of the substrate, the second electrical contact pads being spaced apart from the first electrical contact pads, a plurality of photovoltaic cells each including a plurality of first electrically conductive traces that extend across a first surface of the cells and a plurality of second electrically conductive traces that extend across a second surface of the cells, and microetched conductive tabs electrically connecting the first electrically conductive traces to the second electrical contact pads. The first electrically conductive traces can have a first polarity and the second electrically conductive traces can have a second polarity opposite the first polarity, wherein the first and second electrically conductive traces conduct electric current generated by the photovoltaic cells when illuminated, and wherein a portion of each of the second electrically conductive traces is electrically coupled to one of the first electrical contact pads.

In still another aspect, a method for fabricating a receiver for a concentrating photovoltaic system is provided. The method can comprise positioning a plurality of first electrical contact pads and a plurality of second electrical contact pads on a first surface of a substrate, applying solder paste to the first and second electrical contact pads, placing a plurality of photovoltaic cells on the first electrical contact pads. Each of the photovoltaic cells have a plurality of first electrically conductive traces that extend across a first surface of the cells and a plurality of second electrically conductive traces that extend across a second surface of the cells, wherein the first electrically conductive traces have a first polarity and the second electrically conductive traces have a second polarity opposite the first polarity, wherein the first and second electrically conductive traces conduct electric current generated by the photovoltaic cells when illuminated, and wherein the solder paste connects a portion of each of the second electrically conductive traces to one of the first electrical contact pads. The method can further comprise placing microetched conductive tabs on the second electrical contact pads extending toward the first electrically conductive traces, applying heat to re-flow the solder paste, removing application of the heat to solidify the re-flowed solder paste, which can connect the second electrically conductive traces to the first electrical contact pads and connect the conductive tabs to the second electrical contact pads, and soldering the conductive tabs to the first electrically conductive traces.

Although some of the aspects of the subject matter disclosed herein have been stated hereinabove, and which are achieved in whole or in part by the presently disclosed subject matter, other aspects will become evident as the description proceeds when taken in connection with the accompanying drawings as best described hereinbelow.

### BRIEF DESCRIPTION OF THE DRAWINGS

The features and advantages of the present subject matter will be more readily understood from the following detailed description which should be read in conjunction with the accompanying drawings that are given merely by way of explanatory and non-limiting example.
Figure 1 is a perspective view of a receiver for a concentrating photovoltaic system according to an embodiment of the presently disclosed subject matter;
Figures 2A and 2B are a detail perspective view of the receiver shown in Figure 1;
Figure 3 is an exploded view of the receiver shown in Figure 1;
Figure 4 is a perspective view of an electrical contact arrangement for use with a receiver for a concentrating photovoltaic system according to an embodiment of the presently disclosed subject matter;
Figure 5 is a perspective view of a receiver for a concentrating photovoltaic system according to another embodiment of the presently disclosed subject matter;
Figure 6 is an exploded view of the receiver shown in Figure 5;
Figure 7 is a top view of the receiver shown in Figure 5;
Figure 8 is a perspective view of an electrical contact arrangement for use with a receiver for a concentrating photovoltaic system according to an embodiment of the presently disclosed subject matter; and
Figure 9 is a perspective view of an electrical connector for use with a receiver for a concentrating photovoltaic system according to an embodiment of the presently disclosed subject matter.

### DETAILED DESCRIPTION

The present subject matter provides receivers for concentrating photovoltaic systems and methods for fabricating such receivers. It is noted that the physical scale of the components in a receiver for a concentrating photovoltaic system can be similar to the scale of electronic circuit boards and circuit elements. In this regard, because the fabrication methods for electronic circuitry are highly advanced, comparatively inexpensive, and well-understood, it is believed that photovoltaic receiver fabrication can incorporate the advantages of this well-developed industry to reduce the material and assembly costs of the receiver to a level below that of "one-sun" panels, thereby enhancing rather than negating the cost savings inherent to concentrating photovoltaic systems.

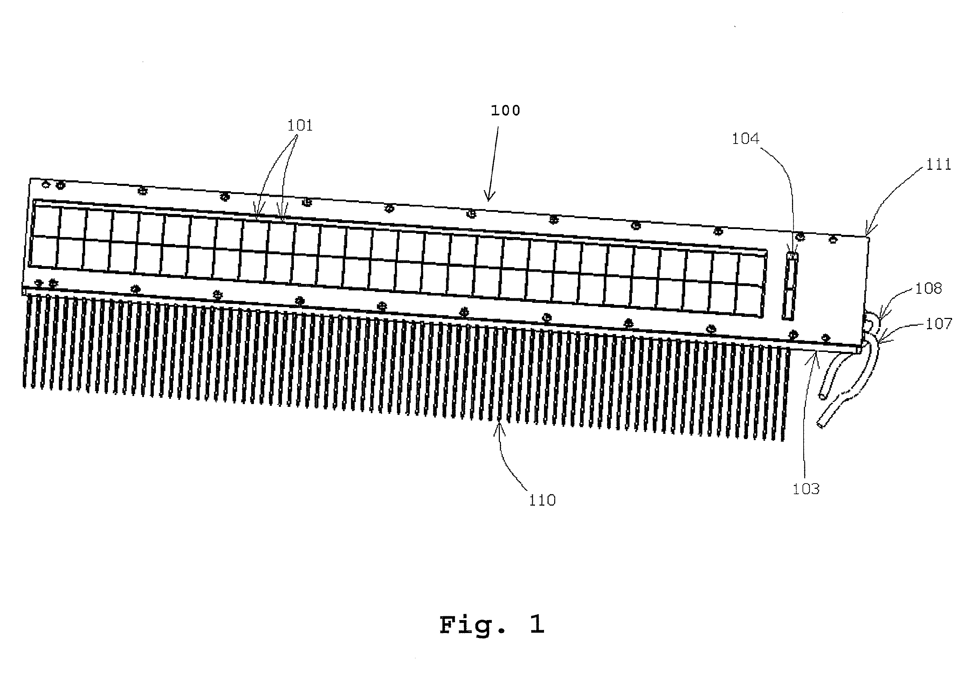

For instance, in one aspect shown in Figures 1-4, the present subject matter provides a receiver for a concentrating photovoltaic system, generally designated **100,** which can include string of photovoltaic cells **101** ("solar cells") contained in a multi-layer component. For example, receiver **100** can include a plurality of photovoltaic cells **101** joined into a circuit using a printed circuit board **102.** For example, circuit board **102** can be a metal circuit card, such as an aluminum or copper circuit card, with one or more insulating dielectric layers (i.e., nonconducting layers) and etched or plated copper traces on a front surface of circuit board **102** for electrical connection. Such mass-producible circuit cards are commonly used in power supplies, where thermal conduction to a heat dissipation device is required, because this kind of circuit card can provide superior heat conduction. For instance, a number of manufacturers (e.g. Bergquist, Alpine, ACS) offer these cards as a standard product. Alternatively, circuit board **102** can be a fiberglass circuit board with bonded copper wiring and conformally-coated solder masks on a front surface of circuit board **102.** Such fiberglass circuit boards generally cost less and provide higher thermal resistance than metal circuit cards. A large number of manufacturers provide low-cost printed circuit boards of this nature and even offer custom production with short lead times.

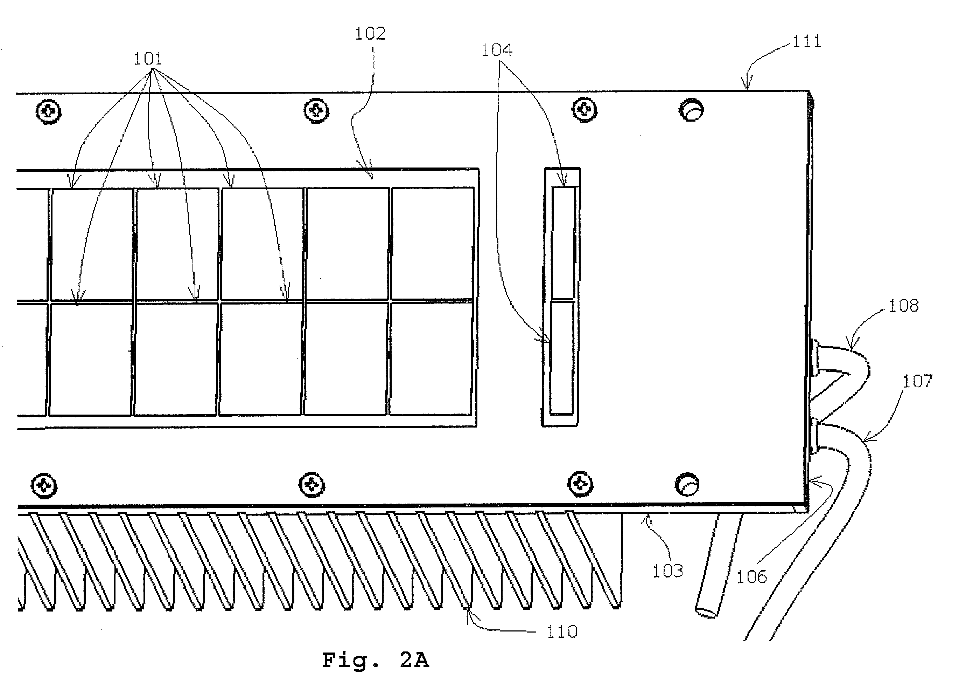

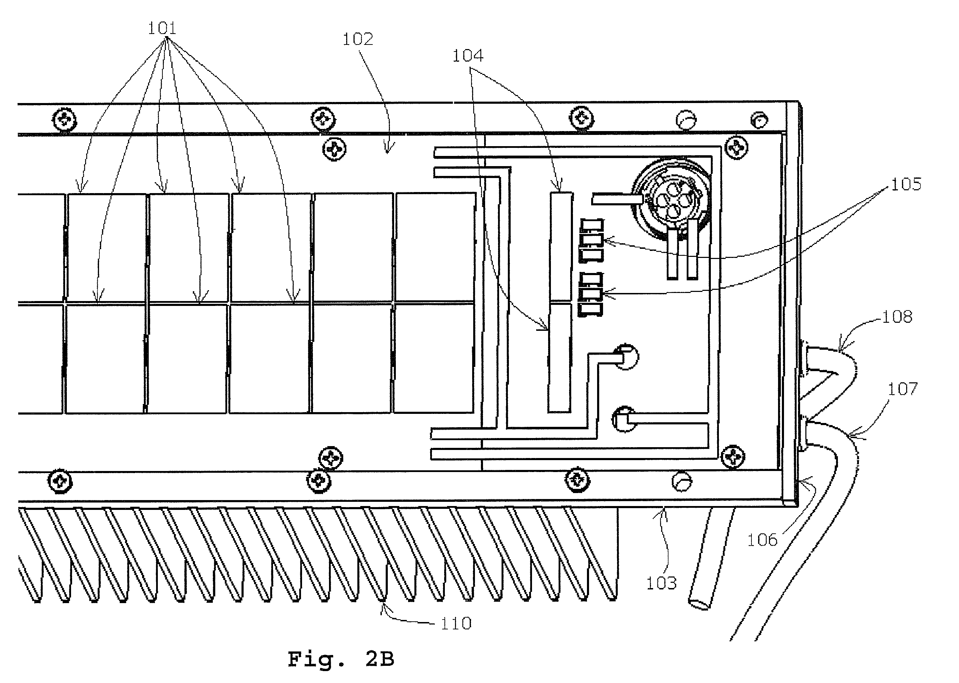

Regardless of the material selected for circuit board **102,** the entire back surface of circuit board **102** can be copper coated and thermally connected to the front surface by plated through holes ("vias"). These holes can be isolated from the circuits on the front surface so that they provide a thermal path without shorting power to the back surface of circuit board **102.** Circuit board **102** can further be thermally coupled to a heat-spreading backplane **103.** Referring to Figures 2A and 2B, receiver **100** may further include incident light sensors **104,** electrical resistors **105,** and positive and negative power leads **107** and **108.**

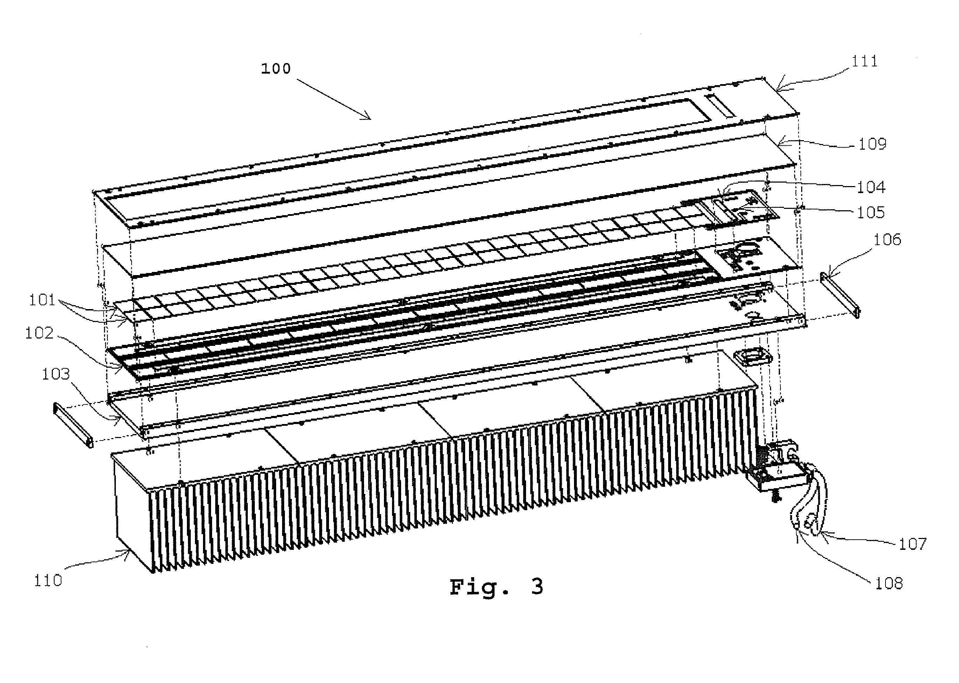

Endcaps **106** can be attached at ends of backplane **103** to create a tray. This tray formed by backplane **103** and endcaps **106** can be filled with a layer of weather-sealing encapsulant **109** on top of photovoltaic cells **101** as illustrated in Figure 3. For instance, encapsulant **109** can be a hard-drying silicone encapsulant that can serve as the outer optical front surface of receiver **100.** Receiver **100** can further include a heat sink or group of heat sinks **110** thermally coupled to backplane **103,** and a cover **111** can be positioned over photovoltaic cells **101** with cutouts around photovoltaic cells **101** and incident light sensors **104.**

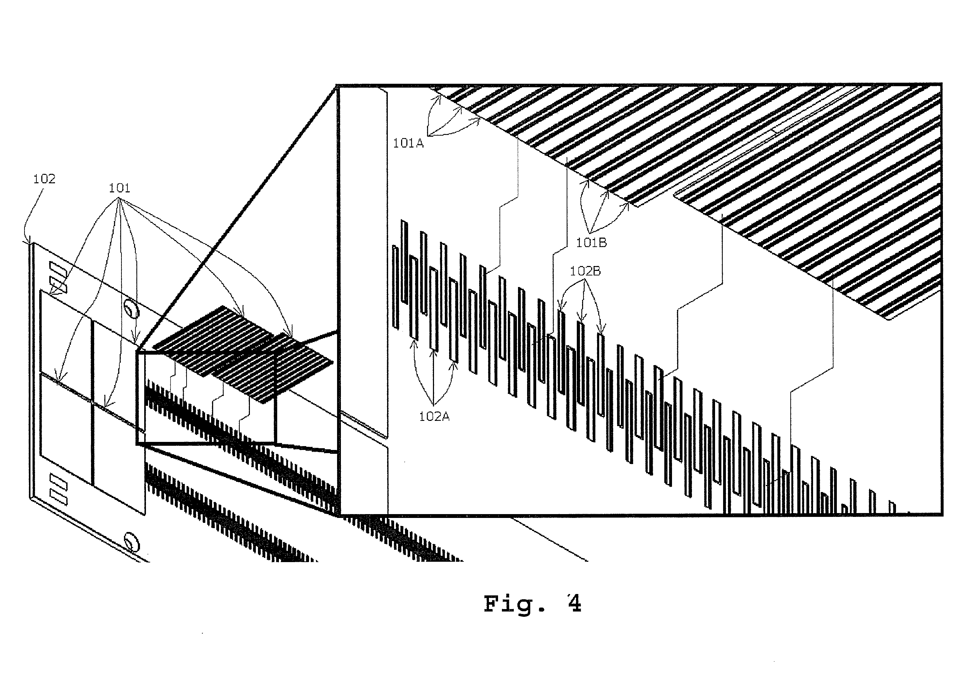

Referring to Figure 4, each of photovoltaic cells **101** can have a front surface for exposure to a light source during use and a back surface opposite the front surface. The back surface of each of photovoltaic cells **101** can have a pattern of positive contacts **101A** and negative contacts **101B,** which can be electrically joined to corresponding positive traces **102A** and negative traces **102B** on printed circuit board **102,** such as by soldering. As shown in Figure 4, for example, these positive and negative contacts **101A** and **101B** can be arranged in an alternating, staggered pattern. In any arrangement, the contacts can be coupled to the traces entirely on the back surface of photovoltaic cells **101.** For instance, these connections can be made when photovoltaic cells **101** are connected to circuit board **102.** As a result, photovoltaic cells **101** can be connected to circuit board **102** in a single fabrication step.

The positioning of both positive contacts and negative contacts **101A** and **101B** on a back surface of photovoltaic cells **101** can provide a number of advantages. For instance, creating these connections entirely on a back surface of photovoltaic cells **101** avoids the need for straps on the edges of photovoltaic cells **101** to join together, separately, the positive and negative interdigitated traces. Also, creating these connections at or near a central region of the back surface can reduce series resistance in positive contacts and negative contacts **101A** and **101B** by as much as factor of four. Further, these connections at the back surface can serve a dual purpose of providing the electrical connection and increase thermal conduction from photovoltaic cells **101** into circuit board **102** and/or backplane **103.**

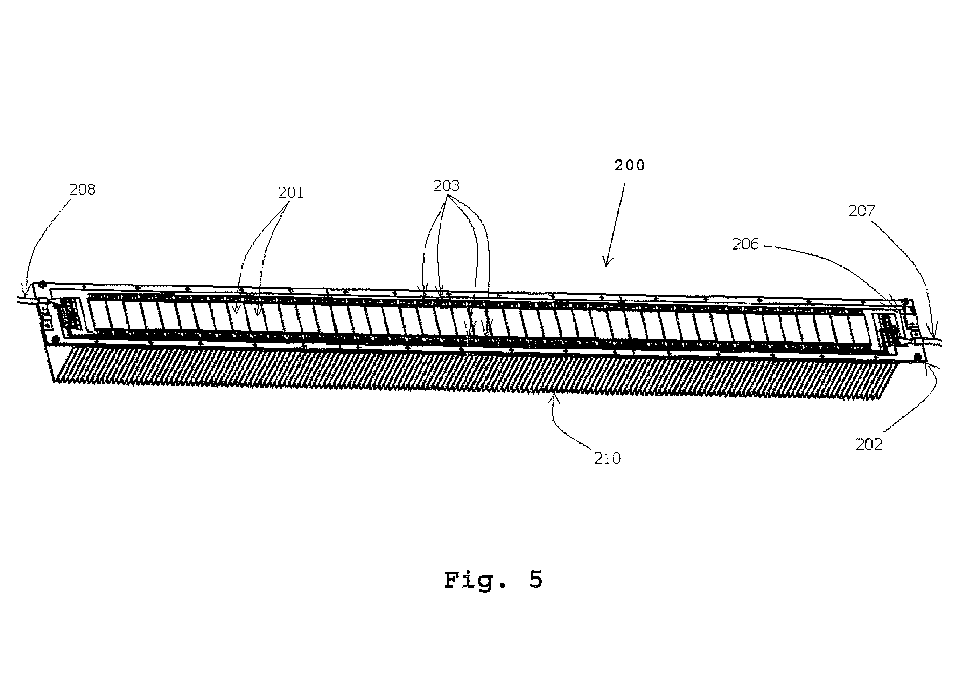

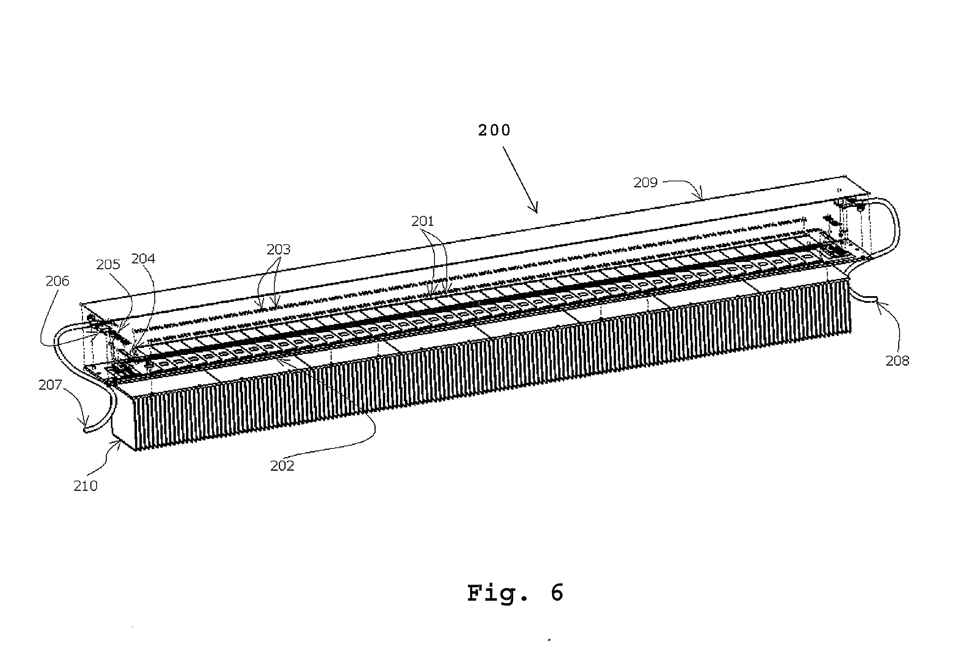

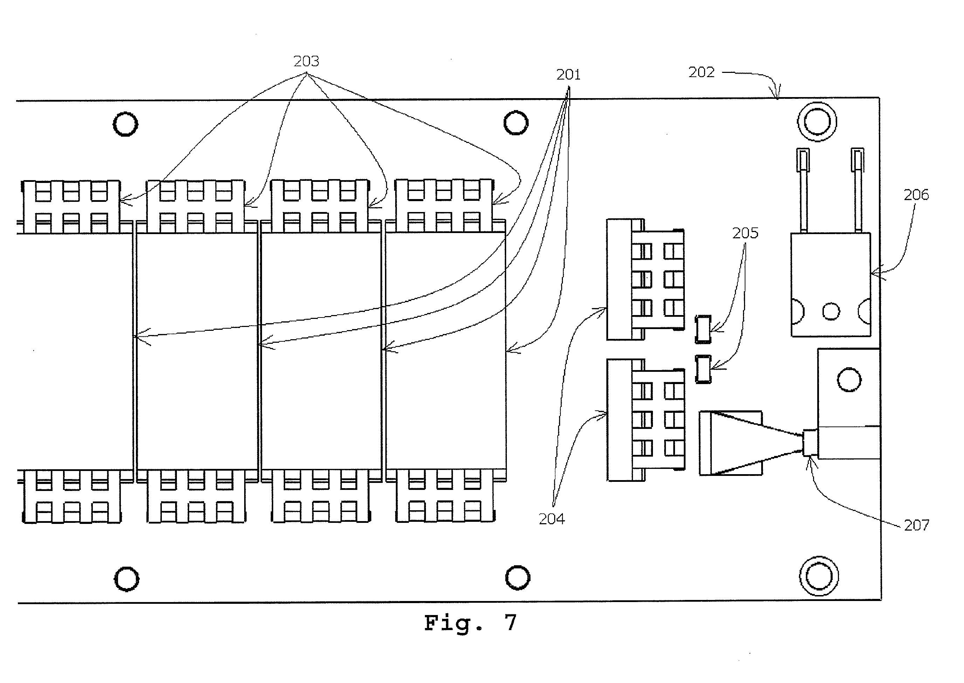

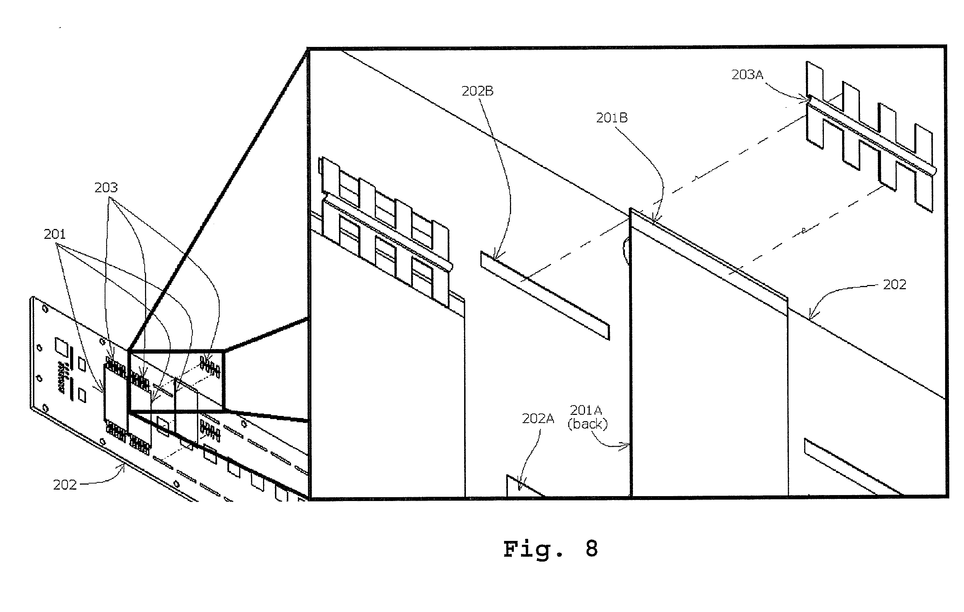

In an alternative embodiment of the presently disclosed subject matter shown in Figures 5-9, the present subject matter provides another configuration for a receiver for a concentrating photovoltaic system, generally designated **200,** which can likewise include a string of photovoltaic cells **201** joined into a circuit using a printed circuit board **202.** Similarly to the configuration discussed above, receiver **200** can include incident light sensors **204,** electrical resistors **205,** bypass diode **206,** and positive and negative power leads **207** and **208,** all underneath a layer of weather-sealing encapsulant **209** and thermally coupled to a heat sink or group of heat sinks **210.**

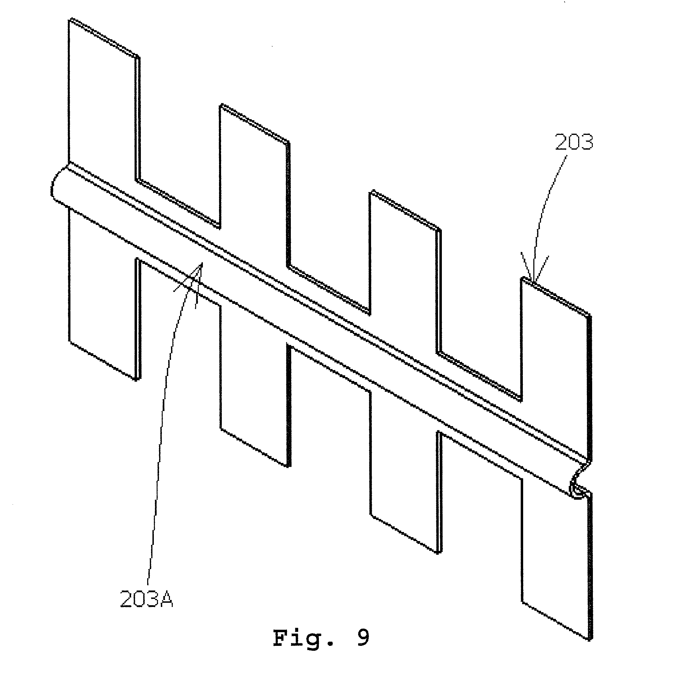

Positive contacts **201A** of each of photovoltaic cells **201** can be located on a back surface of photovoltaic cells **201,** these positive contacts **201A** being electrically connected to a corresponding positive trace **202A** on the printed circuit board. In contrast to the previous configuration, however, negative contacts **201 B** of photovoltaic cells **201** can be located on a front surface of photovoltaic cells **201.** These negative contacts **201 B** can be electrically connected to corresponding negative traces **202B** on the printed circuit board by means of electrical connectors **203,** which can be copper tabs that are etched or micro-machined. Because photovoltaic cells **201** and circuit board **202** can be composed of different materials, electrical connectors **203** can be designed to provide some degree of strain relief to account for differences in thermal expansion of the different materials. In particular, for instance, electrical connectors **203** can have a plurality of individual connector arms extending from a center portion **203A** having strain-relief geometry shown in Figure 9. Both the strain-relief geometry and the individual connector arms can allow movement of the edges of photovoltaic cells **201** relative to circuit board **202,** such as during differential thermal expansion.

Regardless of the specific configuration of components, the fabrication of receiver **100** or **200** can be performed using industry standard soldering techniques often used in the electronics industry. Discussion of an exemplary fabrication process below will make reference to the components described above with respect to receiver **100** except where otherwise indicated, but it should be understood that the same fabrication methods can be used with respect to receiver **200.** Copper circuit traces can be printed on circuit board **102** and covered with a dielectric except at exposed copper soldering pads, which can function as traces **102A** and **102B** where photovoltaic cells **101** and other receiver components can make contact. A solder paste can be applied to these pads, such as by using electronics industry standard screening equipment. Photovoltaic cells 101 and other components can be placed on the pads using standard "pick and place" equipment developed for circuit board manufacturing (e.g., vacuum pick-and-place).

Once the desired components are assembled, circuit board **102** can be passed through a reflow oven to fuse contacts **101A** and **101 B** on the back of photovoltaic cells **101** to the exposed traces **102A** and **102B** on the circuit card. In the configuration discussed above with respect to receiver **100,** photovoltaic cells **101** can have both positive contacts **101A** and negative contacts **101B** on a back surface of photovoltaic cells **101,** with can provide complete electrical connection of photovoltaic cells **101** after passage through the reflow stage. In contrast, in the configuration discussed with respect to receiver **200,** a front connection can also be provided, which can be accomplished by a second step in which electrical connectors **203** are placed so that they bridge from the busbars on the front surface of photovoltaic cells **201** (i.e., negative contacts **201B**) to separate exposed pads on the circuit board (i.e., negative traces **202B**). Electrical connectors **203** can be placed and reflow-soldered using the same standard equipment. Separate circuit elements, including bypass diodes, pigtail or surface-mount power connectors, light sensors, and surface mount technology (SMT) resistors can be placed and soldered at the same time as photovoltaic cells **201.**

In addition to the relative ease of fabrication that can be achieved by this process over conventional receiver fabrication methods, the disclosed methods can also improve the attachment of photovoltaic cells **101** to other components, such as circuit board **102.** Specifically, there is a tendency of differential thermal expansion of crystalline photovoltaic cells and their metal back contacts to warp during the reflow process. Depending on how the components are secured together, this differential expansion can lead to strains that can result in damage to photovoltaic cells **101.** For instance, if positive and negative contacts **101A** and **101 B** are connected to corresponding traces **102A** and **102B** at different edges of photovoltaic cells **101,** the differences in the expansion of photovoltaic cells **101** relative to circuit board **102** can cause photovoltaic cells **101** to buckle and potentially crack.

To help avoid such issues, the arrangement of contacts can be selected to anticipate the differential expansion of the components. For instance, in the configuration discussed above with respect to receiver **100,** positive and negative contacts **101A** and **101 B** can both be provided at or near a center region of a back surface of photovoltaic cells **101.** In this configuration, the warping of photovoltaic cells **101** in the reflow oven can cause the edges of photovoltaic cells **101** to lift away from underlying substrate (e.g., circuit board **102**), which can provide clearance for the soldered connection to create a solid bond between the components. Additionally, upon thermal relaxation and cooling of the components, the edges of photovoltaic cells **101** can press back against circuit board **102,** which can induce mechanical stress to hold the cantilevered cell edges flat on circuit board **102.**

Likewise, in the configuration discussed above with respect to receiver **200,** positive contacts **201A** can both be provided at or near a center region of a back surface of photovoltaic cells **201.** This arrangement can allow thermal expansion and contraction of photovoltaic cells **201** during reflow bonding of positive contacts **201A** with corresponding positive traces **202A.** Once photovoltaic cells **201** are secured to circuit board **202** by this electrical connection, electrical connectors **203** can be attached to electrically connect negative contacts **201 B** with corresponding positive traces **202B.**

The final product can be encapsulated for durability and weatherability, for instance by depositing an encapsulant **109** on photovoltaic cells **101,** such as a transparent liquid silicone-based compound. Again, printed circuit board fabrication techniques can provide a ready solution for this problem. For instance, circuit board **102** can be assembled to a backplane **103** (e.g., an extruded or machined metal housing), with the back surface of circuit board **102** being coupled thermally to backplane **103** with a thermally conductive compound. Power and light sensor connection to circuit board **102** can be made via NEMA connectors passing through backplane **103.** Liquid silicone (potting) encapsulant can be poured to cover and seal all of photovoltaic cells **101** and electronic components, while providing a transparent optical coupling to photovoltaic cells **101** and their anti-reflective surfaces.

Alternatively, the same spray equipment used to apply conformal insulating coatings to electronics can be used to apply a thick layer (e.g., about 0.030 inch thick) of a transparent conformal encapsulation to the entire front side of the cell assembly while in said housing. By way of specific example, this coating can be Dow 1-2620 conformal coating. As with many of the process steps discussed herein, the equipment that can be used for spray or pour dispensing is usually available in the same kinds of facilities that fabricate and populate the circuit card, allowing end-to-end production in a single electronics fabrication plant.

As discussed above, backplane **103** can further be assembled to a heat sink **110** using a thermally-conductive grease, epoxy, or adhesive film. Alternately, heat sink **110** can be integral to backplane **103,** eliminating the thermal resistance in the joint between heat sink **110** and backplane **103.** Alternatively, heat sink **110** can be integral to circuit board **102** itself, with traces **102A** and **102B** being patterned on to a front surface of heat sink **110,** eliminating thermal transfer junctions between circuit board **102** and backplane **103** and between backplane **103** and heat sink **110.** In yet a further alternative, circuit board **102** can be assembled directly to a front surface of heat sink **110,** eliminating backplane **103** and one thermal transfer junction and utilizing spray encapsulation of circuit board **102** without potting.

In addition, electronics industry standard X-ray inspection equipment can be used to check hidden connections (e.g., solder joints) between contacts of photovoltaic cells **101** and traces of circuit board **102** for development and quality assurance. Accordingly, the method for fabricating solar receiver **100** for low-to-intermediate concentration photovoltaic systems not only leverages the fabrication materials and methods developed over decades for the electronics industry, it also allows testing and evaluation of the final product using standard test equipment usually available at the fabrication site. Numerous other advantages in handling, packaging, quality assurance, production yield, and documentation will be apparent to those with experience in the electronic industry, or skilled in the art of solar panel production.

The present subject matter can be embodied in other forms without departure from the spirit and essential characteristics thereof. The embodiments described therefore are to be considered in all respects as illustrative and not restrictive. Although the present subject matter has been described in terms of certain preferred embodiments, other embodiments that are apparent to those of ordinary skill in the art are also within the scope of the present subject matter.

## Claims

1. A receiver for a concentrating photovoltaic system, the receiver comprising:
a substrate, at least a portion of which is thermally conductive;
a plurality of electrical contact pads located on a first surface of the substrate; and
a plurality of photovoltaic cells, each of the photovoltaic cells having a first surface for exposure to a light source during use and a second surface opposite the first surface, wherein the second surface includes a plurality of electrically conductive traces that extend across the second surface for conduction of electric current generated by the photovoltaic cells when illuminated, wherein at least a portion of each of the electrically conductive traces is electrically coupled to one of the electrical contact pads.

2. The receiver of claim 1, wherein the substrate comprises a printed circuit board.

3. The receiver of claim 1 or claim 2, comprising a heat-spreading backplane coupled to a second surface of the substrate opposite the first surface.

4. The receiver of any preceding claim, wherein the electrically conductive traces are located at or near a center region of the second surface, and/or wherein the electrically conductive traces comprise alternating positive and negative traces, and/or wherein at least a portion of each of the electrically conductive traces is soldered to one of the electrical contact pads.

5. The receiver of any preceding claim, comprising an electrically nonconducting layer covering at least a portion of the first surface of the substrate except where the electrical contact pads are located, and/or wherein the receiver comprises an encapsulating layer over the plurality of photovoltaic cells.

6. A method for fabricating a receiver for a concentrating photovoltaic system, the method comprising:
positioning a plurality of electrical contact pads on a first surface of a substrate, at least a portion of the substrate being thermally conductive;
applying solder paste to the electrical contact pads;
placing a plurality of photovoltaic cells on the electrical contact pads, each of the photovoltaic cells having a first surface for exposure to a light source during use and a second surface opposite the first surface, wherein the second surface includes a plurality of electrically conductive traces that extend across the second surface for conducting electric current generated by the photovoltaic cells when illuminated, wherein the solder paste connects a portion of each of the electrically conductive traces to one of the electrical contact pads;
applying heat to re-flow the solder paste; and
removing application of the heat to solidify the re-flowed solder paste and connect the electrically conductive traces to the electrical contact pads.

7. The method of claim 6, wherein the solder paste connects a portion of each of the electrically conductive traces at or near a center region of the second surface to one of the electrical contact pads.

8. A receiver for a concentrating photovoltaic system, the receiver comprising:
a substrate, at least a portion of which is thermally conductive;
a plurality of first electrical contact pads on a first surface of the substrate;
a plurality of second electrical contact pads on the first surface of the substrate, the second electrical contact pads being spaced apart from the first electrical contact pads;
a plurality of photovoltaic cells, each of the photovoltaic cells having a first surface for exposure to a light source during use and a second surface opposite the first surface, wherein the first surface includes a plurality of first electrically conductive traces that extend across the first surface and the second surface includes a plurality of second electrically conductive traces that extend across the second surface, wherein the first electrically conductive traces have a first polarity and the second electrically conductive traces have a second polarity opposite the first polarity, wherein the first and second electrically conductive traces conduct electric current generated by the photovoltaic cells when illuminated, and wherein a portion of each of the second electrically conductive traces is electrically coupled to one of the first electrical contact pads; and
microetched conductive tabs electrically connecting the first electrically conductive traces to the second electrical contact pads.

9. The receiver of claim 8, wherein the substrate comprises a printed circuit board.

10. The receiver of claim 8 or claim 9, comprising a heat-spreading backplane coupled to a second surface of the substrate opposite the first surface.

11. The receiver of any of claims 8 to 10 , wherein the second electrically conductive traces are at or near a center region of the second surface, and/or wherein each of the second electrically conductive traces is soldered to one of the first electrical contact pads.

12. The receiver of any of claims 8 to 11, wherein the microetched conductive tabs comprise a plurality of connector arms and a strain-relief portion.

13. The receiver of any of claims 8 to 12, comprising an electrically nonconducting layer covering at least a portion of the first surface of the substrate except where the first electrical contact pads and the second electrical contact pads are located, and/or comprising an encapsulating layer over the plurality of photovoltaic cells.

14. A method for fabricating a receiver for a concentrating photovoltaic system, the method comprising:
positioning a plurality of first electrical contact pads and a plurality of second electrical contact pads on a first surface of a substrate, at least a portion of the substrate being thermally conductive;
applying solder paste to the first and second electrical contact pads;
placing a plurality of photovoltaic cells on the first electrical contact pads, each of the photovoltaic cells having a first surface for exposure to a light source during use and a second surface opposite the first surface, wherein the first surface includes a plurality of first electrically conductive traces that extend across the first surface and the second surface includes a plurality of second electrically conductive traces that extend across the second surface, wherein the first electrically conductive traces have a first polarity and the second electrically conductive traces have a second polarity opposite the first polarity, wherein the first and second electrically conductive traces conduct electric current generated by the photovoltaic cells when illuminated, and wherein the solder paste connects a portion of each of the second electrically conductive traces to one of the first electrical contact pads;
placing microetched conductive tabs on the second electrical contact pads extending toward the first electrically conductive traces;
applying heat to re-flow the solder paste;
removing application of the heat to solidify the re-flowed solder paste, connecting the second electrically conductive traces to the first electrical contact pads, and connecting the conductive tabs to the second electrical contact pads; and
soldering the conductive tabs to the first electrically conductive traces.

15. The method of claim 14, wherein the solder paste connects a portion of each of the second electrically conductive traces at or near a center region of the second surface to one of the first electrical contact pads.
